# EUROPEAN PATENT APPLICATION

(11) **EP 2 675 004 A1**
(43) Date of publication of application: **18.12.2013**
(21) Application number: 12745152.4
(22) Date of filing: 10.02.2012
(51) Int. Cl.: H01M 4/66, C23F 1/00, H01G 9/016, H01M 4/64

(54) **CURRENT COLLECTOR**

(30) Priority: 10.02.2011 JP 2011026817
(71) Applicant: Showa Denko K.K., Tokyo 105-8518 (JP)
(72) Inventor: YAMAGUCHI, Tomofumi, Tokyo 105-8518 (JP); OHMORI, Masahiro, Tokyo 105-8518 (JP); YOKOUCHI, Hitoshi, Tokyo 105-8518 (JP)
(74) Representative: Strehl Schübel-Hopf & Partner
(86) International application number: PCT/JP2012/000902
(87) International publication number: WO 2012/108212

(57) **Abstract**

A current collector for an electrochemical element comprising an aluminum foil showing a peak in the range between 945 cm⁻¹ and 962 cm⁻¹ in measurement of a surface layer of the aluminum foil by Fourier transform infrared spectroscopy can be obtained by a manufacturing method comprising the steps of: preparing an aluminum foil material; washing a surface of the aluminum foil material with a chemical solution capable of dissolving aluminum such as hydrochloric acid, aqueous nitric acid, aqueous sulfuric acid, aqueous solutions of alkali metal hydroxides and aqueous solutions of alkaline earth metal hydroxides; and optionally heat treating the aluminum foil at 70 to 200°C and/or forming a coated layer comprising an electrically conducive material, on one or both surfaces of the aluminum foil.

## Description

### TECHNICAL FIELD

The present invention relates to a current collector. More specifically, the present invention relates to a current collector used for an electrochemical element such as a secondary battery, an electric double layer capacitor and the like; a solar cell; a touch panel; and the like.

### BACKGROUND ART

As electrochemical elements, known are secondary batteries such as a lithium-ion secondary battery and a nickel-hydrogen battery; and capacitors such as an electric double layer capacitor and a hybrid capacitor.

In general, an electrode of an electrochemical element comprises a current collector comprising a metal foil such as an aluminum foil and a copper foil; and an electrode active material layer. An undercoat layer is provided on the surface of a current collector if desired. In order to decrease the internal resistance and impedance of an electrochemical element, the penetration resistance of the above current collector and an electrode need to be decreased.

An undercoat layer and an electrode active material layer are formed by applying a coating fluid intended for these to a metal foil. It is known that the performance of a cell which uses an electrode comprising a current collector having an undercoat layer varies depending on the surface conditions of the metal foil. For example, Patent Literature 1 describes that a metal foil in which the contact angle with water is less than 40° is preferably used as a current collector. Patent Literature 2 suggests that a current collector comprising an aluminum core body in which the contact angle with N-methyl pyrrolidone is 45° or less. Further, Patent Literature 3 describes a method of treating a current collector for a secondary battery, the method comprising: allowing a metal current collector to be reacted in an acidic aqueous solution at 20 to 80°C or in a basic aqueous solution at 20 to 90°C for 10 minutes or less; then washing with pure water; and drying. In the treatment according to Patent Literature 3, the reaction in the acidic or basic aqueous solution generates boehmite on the surface of the metal current collector. When it is dried, a surface oxide layer having a void is formed, leading to an increased specific surface area of the metal current collector. Patent Literature 4 describes a method of manufacturing a current collector for a lithium ion battery, the method comprising: washing an aluminum grid with a basic solution to remove an alumina layer present on a surface of the grid; and then coating the washed aluminum grid with zinc.

### PRIOR ARTS LIST

Patent Literature 1: JP H11-288722 A
Patent Literature 2: JP 2005-050679 A
Patent Literature 3: WO 00/07253 A
Patent Literature 4: JP H10-241695 A

### SUMMARY OF THE INVENTION

### PROBLEMS TO BE RESOLVED BY THE INVENTION

An object of the present invention is to provide a current collector used for an electrochemical element such as a secondary battery, an electric double layer capacitor and the like; a solar cell; a touch panel; and the like, wherein penetration resistance is low and a time dependent change in the penetration resistance is small.

### MEANS FOR SOLVING THE PROBLEMS

The present invention encompasses the followings:
[1] A current collector for an electrochemical element comprising an aluminum foil showing a peak in the range between 945 cm⁻¹ and 962 cm⁻¹ in measurement of a surface layer of the aluminum foil by Fourier transform infrared spectroscopy.
[2] The current collector for an electrochemical element according to [1], further comprising a coated layer comprising an electrically conductive material, on one or both surfaces of the aluminum foil.
[3] The current collector for an electrochemical element according to [2], wherein the coated layer comprises a binder.
[4] The current collector for an electrochemical element according to [3], wherein the binder comprises a polysaccharide.
[5] The current collector for an electrochemical element according to [4], wherein the coated layer comprises carboxylic acid or a derivative thereof.
[6] The current collector for an electrochemical element according to any one of [2] to [5], wherein the electrically conductive material is a carbonaceous material.
[7] A method of manufacturing a current collector for an electrochemical element, the current collector comprising an aluminum foil showing a peak in the range between 945 cm⁻¹ and 962 cm⁻¹ in measurement of a surface layer of the aluminum foil by Fourier transform infrared spectroscopy, the method comprising the steps of preparing an aluminum foil material; and washing a surface of the aluminum foil material with a chemical solution capable of dissolving aluminum.
[8] The method of manufacturing a current collector for an electrochemical element according to [7], wherein the chemical solution is an acidic aqueous solution or an alkaline aqueous solution.
[9] The method of manufacturing a current collector for an electrochemical element according to [7], wherein the chemical solution comprises one or more selected from the group consisting of hydrochloric acid, aqueous nitric acid and aqueous sulfuric acid.
[10] The method of manufacturing a current collector for an electrochemical element according to [7], wherein the chemical solution comprises one or more selected from the group consisting of aqueous solutions of alkali metal hydroxides and aqueous solutions of alkaline earth metal hydroxides.
[11] The method of manufacturing a current collector for an electrochemical element according to any one of [7] to [10], further comprising a step of heat treating the aluminum foil at 70 to 200°C after washing with the chemical solution.
[12] The method of manufacturing a current collector for an electrochemical element according to any one of [7] to [11], further comprising a step of forming a coated layer comprising an electrically conductive material, on one or both surfaces of the aluminum foil.
[13] The method of manufacturing a current collector for an electrochemical element according to [12], wherein the step of forming the coated layer comprises applying a coating fluid.
[14] An electrode for an electrochemical element comprising the current collector for an electrochemical element according to any one of [1] to [6] and an active material layer provided on one or both surfaces of the current collector.
[15] An electrochemical element comprising the electrode for an electrochemical element according to [14].
[16] The electrochemical element according to [15], which is a lithium-ion secondary battery or an electric double layer capacitor.

### ADVANTAGEOUS EFFECT OF THE INVENTION

The current collector according to the present invention has low penetration resistance and a small time dependent change in penetration resistance. The electrode according to the present invention can provide an electrochemical element having low internal resistance or impedance. The current collector or the electrode according to the present invention can be conveniently used for an electrochemical element such as a secondary battery and an electric double layer capacitor; a solar cell; a touch panel; and the like.

A surface of an aluminum foil is usually covered with an oxide layer. An oxide layer on a surface of the conventional aluminum foil contains a void and an impurity. Therefore, a peak is observed around 930 cm⁻¹ to 944 cm⁻¹ when a surface layer of the conventional aluminum foil is measured by Fourier transform infrared spectroscopy (see Comparative Example 1). In contrast, the aluminum foil used for the current collector in the present invention has a peak in the range of 945 cm⁻¹ to 962 cm⁻¹ in measurement of a surface layer of the aluminum foil by Fourier transform infrared spectroscopy. The oxide layer covering the aluminum foil used for the current collector in the present invention is supposed to have fewer voids and impurities, and to be denser. As a result, the affinity with an undercoat layer and an electrode active material layer which are to be provided on a surface of an aluminum foil will be high, and the occurrence of poor electric conduction decreases, resulting in achieving the above effects.

### BRIEF DESCRIPTION OF THE DRAWINGS

[Fig. 1] a spectrum obtained by measuring a surface of the aluminum foil manufactured in Example 1 by Fourier transform infrared spectroscopy.
[Fig. 2] a spectrum obtained by measuring a surface of the aluminum foil manufactured in Comparative Example 1 by Fourier transform infrared spectroscopy.

### EMBODIMENTS FOR CARRYING OUT THE INVENTION

The current collector according to the present invention comprises an aluminum foil showing a peak in the range of 945 cm⁻¹ to 962 cm⁻¹ in measurement of a surface layer of the aluminum foil by Fourier transform infrared spectroscopy.

### (Aluminum foil)

The aluminum foil used in the present invention shows a peak in the range of 945 cm⁻¹ to 962 cm⁻¹, more preferably in the range of 948 cm⁻¹ to 955 cm⁻¹, even more preferably in the range of 951 cm⁻¹ to 954 cm⁻¹ in measurement of a surface layer of the aluminum foil by Fourier transform infrared spectroscopy.

Measurements by Fourier transform infrared spectroscopy are performed under the following conditions. An incident angle is adjusted so that the maximum sensitivity is obtained at an incident angle between 75° and 85°, and only parallel polarized light is monitored using a polarizer by the reflection method. In view of measurement accuracy and time required for a measurement, the resolution is set to 2 cm⁻¹ to 4 cm⁻¹, and integration is performed 1000 times. A vapor deposited gold mirror is used as a background. For each peak showing an absorbance of 0.02 or more against the baseline, a wave number corresponding to the maximum absorbance is recorded as a peak position.

There is no particular limitation for a thickness of the aluminum foil used in the present invention, but the thickness of the aluminum foil is preferably 5 µm to 200 µm, more preferably 10 µm to 100 µm in view of downsizing an electrochemical element, and handling properties of an aluminum foil and a current collector or an electrode obtained using the aluminum foil.

Aluminum foil materials conventionally used as an electrode base material for an electrochemical element can be used. Any of the followings can be used: pure aluminum foils (1000 series materials such as A1085) and aluminum alloy foils with 95 % by mass or more purity (2000 series [Al-Cu alloy], 3000 series [Al-Mn alloy] such as A3003, 4000 series [Al-Si alloy], 5000 series [Al-Mg alloy], 6000 series [Al-Mg-Si alloy] and 7000 series [Al-Zn-Mg alloy]). For example, when used for a positive electrode of a lithium-ion secondary battery, or an electrode of an electric double layer capacitor, aluminum foil materials include a pure aluminum foil comprising Si: 0.10 % by mass or less, Fe: 0.12 % by mass or less, Cu: 0.03 % by mass or less, Mn: 0.02 % by mass or less, Mg: 0.02 % by mass or less, Zn: 0.03 % by mass or less, Ga: 0.03 % by mass or less, V: 0.05 % by mass or less, Ti: 0.02 % by mass or less and Al: 99.85 % by mass or more, and other elements: 0.01 % by mass or less for each, or an aluminum alloy foil comprising Si: 0.6 % by mass or less, Fe: 0.7 % by mass or less, Cu: 0.05 to 0.20 % by mass, Mn: 1.0 to 1.5 % by mass and Zn: 0.10 % by mass or less, and other elements: 0.05 % by mass or less for each and 0.15 % by mass or less in total, the remainder being Al. A form of the aluminum foil may be a foil having no opening, or may be a foil having an opening such as a mesh foil and a punching metal foil.

### (Method of manufacturing the aluminum foil)

An aluminum foil showing a peak in the above range as measured by Fourier transform infrared spectroscopy can be obtained, for example, by the following method.

First, an aluminum foil material is obtained by rolling aluminum to a predetermined thickness. There is no particular limitation for a rolling method, but preferred is a method in which a cold rolling machine is used. Rolling oil remained on a surface of the aluminum foil material may be removed using a surfactant and a solvent. The aluminum foil material may have a dull surface having minute unevenness on one surface of it and a smoothed glossy surface on the other surface, or may have dull surfaces on the both surfaces, or may have glossy surfaces on the both surfaces. Among these, the aluminum foil material having a dull surface on one surface and a glossy surface on the other surface is preferred.

Subsequently, the surface of the aluminum foil material is washed with a chemical solution capable of dissolving aluminum. Aluminum is dissolved by washing, and an oxide layer on the surface of the aluminum foil material is modified to reduce voids and impurities, and the texture appears to become fine. Preferably, washing is performed by immersion washing. Supersonic waves and the like may be applied during the immersion washing.
A thickness corresponding to the dissolved amount of aluminum in the washing is preferably 10 nm to 1000 nm. More particularly, depending on rolling history and the like, it is usually 200 to 400 nm, and in a case where contamination and voids on the surface are less, it is preferably 10 to 200 nm, and in a case where contamination and voids on the surface are significant, it is preferably 400 to 1000 nm. Here, a thickness corresponding to the dissolved amount is computed by the following procedures. A chemical solution used for washing an aluminum foil material is analyzed with an inductively coupled plasma atomic emission spectroscopy system to calculate the mass of aluminum in the solution. Based on the density of the aluminum foil material (for example, in the case of pure aluminum, 2.7 g/cm³), the mass of aluminum in the solution is converted into a volume, and a value obtained by dividing the volume by the area of the aluminum foil material used is taken as a thickness corresponding to the dissolved amount.

Examples of a chemical solution capable of dissolving aluminum include an acidic aqueous solution or an alkaline aqueous solution. Examples of an acidic aqueous solution include hydrochloric acid, aqueous nitric acid, aqueous sulfuric acid and the like. Examples of an alkaline aqueous solution include aqueous solutions of alkali metal hydroxides such as aqueous sodium hydroxide, aqueous potassium hydroxide and the like, and aqueous solutions of alkaline earth metal hydroxides such as magnesium hydroxide, calcium hydroxide and the like. The acidic aqueous solution has a concentration of usually 0.1 to 30 % by mass, preferably 0.5 to 20 % by mass, and more preferably 1 to 10 % by mass. The alkaline aqueous solution has a concentration of usually 0.1 to 30 % by mass, preferably 0.1 to 10 % by mass, and more preferably 0.1 to 5 % by mass. Temperature at the time of washing is preferably not less than 10°C and not more than 80°C, more preferably not less than 10°C and less than 40°C.

Subsequently, it can be rinsed with pure water. There is no particular limitation for the number of rinsing and the amount of pure water to be used. Note that in a case where an alkaline aqueous solution is used as a chemical solution, a neutralization treatment is preferably performed with 0.1 to 5 mol/L of sulfuric acid before rinsing with pure water. Temperature of pure water at the time of rinsing is preferably 20 to 80°C, more preferably 30 to 50°C. Note that types of pure water include distilled water, RO water, deionized water, purified water [Japanese Pharmacopoeia] and the like. The concentration of impurities in pure water is preferably 1000 µg/L or less, more preferably 10 µg/L or less. The electric conductivity of pure water is preferably 1 µS/cm or less, more preferably 0.07 µS/cm or less.
After rinsing, a heat treatment is performed at preferably 70 to 200°C, more preferably 80 to 180°C for 1 to 5 minutes under an atmospheric environment.
Moisture and volatile components are removed by the heat treatment. Note that the temperature and time for the heat treatment can be adjusted as follows. First, a trial heat treatment is performed. Then, a surface layer of the resulting current collector is measured by Fourier transform infrared spectroscopy.
In a case where a peak is observed in a region of wave number lower than the target wave number, the temperature for the actual heat treatment will be increased or the treatment time will be shortened. In a case where a peak is observed in a region of wave number higher than the target wave number, the temperature for the actual heat treatment will be decreased or the treatment time will be prolonged. Adjustment of the temperature and time for the heat treatment as described above is preferably performed when a thickness corresponding to the dissolved amount is 400 nm or more.

### (A Coated layer containing an electrically conductive material)

Preferably, the current collector according to the present invention further comprises a coated layer comprising an electrically conductive material, on one or both surfaces of the aluminum foil. The coated layer functions as the undercoat layer described above, and usually does not comprise an electrode active material. In view of downsizing an electrochemical element, and reducing internal resistance or impedance, a thickness of the coated layer is preferably 0.1 to 10 µm, more preferably 0.5 to 5 µm, and the layer weight per unit area is preferably 0.2 to 5 g/m², more preferably 0.5 to 3 g/m².

### (Electrically conductive material)

The electrically conductive material to be contained in the coated layer is preferably a carbonaceous material having elemental carbon as a main component. Carbonaceous materials include acetylene black, Ketjen black, carbon fiber, carbon nanotube, carbon nanofiber, graphite and the like. Among these, fibrous carbonaceous materials such as carbon fiber, carbon nanotube and carbon nanofiber or acetylene black are preferred. Among fibrous carbonaceous materials, vapor-grown carbon fiber is preferred in view of electric conductivity and dispersibility. These carbonaceous materials can be used alone or in combination of two or more.
Electrically conductive materials other than carbonaceous materials include powders of metals such as gold, silver, copper, nickel, aluminum and the like.

There is no particular limitation for the shape of an electrically conductive material, but the shape may be, for example, a spherical shape, a flat shape, an irregular shape and the like. In the case of a particulate electrically conductive material, the size of the electrically conductive material is preferably 10 nm to 50 µm, more preferably 10 nm to 100 nm in the number average primary particle diameter. In the case of a fibrous electrically conductive material, the number average fiber diameter is preferably 0.001 µm to 0.5 µm, more preferably 0.003 µm to 0.2 µm, and the number average fiber length is preferably 1 µm to 100 µm, more preferably 1 µm to 30 µm. The mean particle diameter, the mean fiber length or the mean fiber diameter of an electrically conductive material can be computed by measuring particle diameters, fiber diameters or fiber lengths of 100 to 1000 pieces of the electrically conductive material using an electron microscope, and then number averaging these.

The electrically conductive material preferably has a powder electrical resistance of 5.0 × 10⁻¹ Ω·cm or less as measured in accordance with JIS K1469.

### (Binder)

The above coated layer preferably comprises a binder in view of the cost for coating formation and the like. Preferred examples of a binder include polysaccharides since they have excellent ion permeability through the coated layer. A polysaccharide is a polymer compound in which a large number of monosaccharides or derivatives thereof are polymerized via the glycosidic linkage. A compound in which ten or more monosaccharides or derivatives thereof are polymerized is usually called a polysaccharide, but a compound in which ten or less monosaccharides are polymerized may be used.

Examples of a preferred polysaccharide include cellulose and chitosan. Preferred is polysaccharides modified with a functional group such as a carboxymethyl group, a carboxyethyl group, a hydroxyethyl group, a hydroxypropyl group, a glyceryl group and the like in view of dispersibility, coatability and the like. Particularly preferred polysaccharides modified with a functional group include glyceryl chitosan. Glyceryl chitosan can be manufactured by, for example, the method described in Japanese Patent No. 3958536 (corresponding to US 2004/092620 A1).

Examples of binders other than polysaccharides include fluorine-containing polymers such as polytetrafluoroethylene, polyvinylidene fluoride and the like; latex such as natural rubber based latex, styrene butadiene rubber based latex, chloroprene rubber based latex and the like; acrylic acid copolymers containing acrylic monomers such as acrylic acid, methacrylic acid, itaconic acid and the like.

The amount of a binder is preferably 10 to 300 parts by mass, more preferably 10 to 200 parts by mass relative to 100 parts by mass of the electrically conductive material.

### (Additives)

The above coated layer may optionally contain additives such as a dispersion stabilizer, a thickener, an anti-settling agent, an anti-skinning agent, a defoaming agent, an electrostatic coating modifier, an anti dripping agent, a leveling agent, an anti-cratering agent, a crosslinking agent, a crosslinking catalyst and the like.

For example, when a polysaccharide is included as a binder, the above coated layer preferably contains carboxylic acid or a derivative thereof as a dispersion stabilizer or a crosslinking agent. Examples of preferred carboxylic acid include pyromellitic acid, 1,2,3,4-butanetetracarboxylic acid or the like.

Further, derivatives of carboxylic acid include esters, acid chlorides, acid anhydrides and the like. Among these, acid anhydrides are preferred.

Carboxylic acid or a derivative thereof can be used alone or in combination of two or more.

The amount of carboxylic acid to be used is preferably 30 to 300 parts by mass, more preferably 40 to 120 parts by mass relative to 100 parts by mass of the polysaccharide.

### (Formation of coated layer)

The coated layer containing the electrically conductive material can be obtained by applying a coating fluid in which the electrically conductive material, the binder and optionally the additive; and a dispersion medium are mixed, on an aluminum foil, and then drying. Examples of the dispersion medium include aprotic polar solvents such as N-methyl pyrrolidone, γ-butyrolactone and the like; protic polar solvents such as ethanol, isopropyl alcohol, n-propyl alcohol and the like; water; and the like. The amount of the dispersion medium in a coating fluid is preferably 70 to 99 % by mass, more preferably 80 to 95 % by mass.

There is no particular limitation for a method of applying and drying, and any known methods used for manufacture of an electrochemical element can be used. Note that in the case where a thermal crosslinkable binder is used as a binder, drying needs to be performed at sufficient temperature and time for cross-linking. For example, in the case where a binder containing a polysaccharide is cross-linked using carboxylic acid or a derivative thereof, drying is preferably performed at 120°C to 250°C for 10 seconds to 10 minutes.

Alternatively, without using a coating fluid, a coated layer containing an electrically conductive material can also be formed by directly depositing an electrically conductive material such as vapor grown carbon fiber, carbon nanotube, carbon nanofiber and the like on a surface of an aluminum foil by a method such as the chemical vapor deposition.

### (Electrode)

An electrode for a lithium-ion secondary battery and an electric double layer capacitor can be obtained by forming an electrode active material layer on a current collector (on a coated layer if the coated layer is formed to be an undercoat layer). There is no particular limitation for a material used for an electrode active material layer and a method of forming an electrode active material layer, and a known material and method used for manufacture of electrochemical elements such as a lithium-ion secondary battery, an electric double layer capacitor and a hybrid capacitor can be used.

The current collector according to the present invention can also be used for an electrode of electrochemical elements other than the above, or for an electrode of a solar cell, a touch panel, a sensor and the like.

### (Electrochemical element)

An electrochemical element comprises the foregoing electrode as well as a separator and an electrolyte, which are covered with an exterior material. With regard to electrodes in the electrochemical element, both of the positive electrode and the negative electrode may be the electrodes according to the present invention. Alternatively, either one may be the electrode according to the present invention while the other may be a known electrode. In a lithium ion battery, at least the positive electrode is preferably the electrode according to the present invention. There is no particular limitation for an electrolyte, a separator and an exterior material as long as they are used in a secondary battery such as a lithium-ion battery, an electric double layer capacitor, a hybrid capacitor and the like.

An electrochemical element can be used for a power supply system. The power supply system can be, in turn, used for automobiles; transportation equipment such as railroad, ship and aircraft; portable devices such as a cellular phone, a personal digital assistant and a handheld computer; office equipment; power generation systems such as a photovoltaic power generation system, a wind turbine generator system and a fuel cell system; and the like.

### EXAMPLES

Now, the present invention will be described more specifically by using Examples and Comparative Examples. Note that the scope of the present invention shall not be limited to Examples. The current collector according to the present invention and a manufacturing method thereof can be suitably modified without departing from the spirit of the present invention.

### (Examples 1 to 3)

### (Manufacture of an aluminum foil)

A pure aluminum foil comprising Si: 0.10 % by mass or less, Fe: 0.12 % by mass or less, Cu: 0.03 % by mass or less, Mn: 0.02 % by mass or less, Mg: 0.02 % by mass or less, Zn: 0.03 % by mass or less, Ga: 0.03 % by mass or less, V: 0.05 % by mass or less, Ti: 0.02 % by mass or less and Al: 99.85 % by mass or more and other elements: 0.01 % by mass or less for each was rolled to prepare an aluminum foil material with a thickness of 50 µm. The aluminum foil material was cut to the size of 20 cm in width and 30 cm in length. The aluminum foil material was immersed in 30 L of hydrochloric acid maintained at 25°C in which the concentration of hydrogen chloride is 2 % by mass, and washed to give a thickness corresponding to the dissolved amount as shown in Table 1. Note that the thickness corresponding to the dissolved amount was adjusted by varying immersion time between 5 seconds and 5 minutes. Note that the thickness corresponding to the dissolved amount was obtained by computing the mass of aluminum dissolved in the chemical solution based on the analytical line of aluminum (167.02 nm) as measured with an inductively coupled plasma atomic emission spectroscopy from SEIKO INSTRUMENTS INC. (Product name VISTA-PRO), and then converting the mass into a volume based on the density of pure aluminum, 2.7 g/cm³, and dividing the volume by the area of the aluminum foil material.
The aluminum foil material was removed from the chemical solution, and well rinsed with pure water having an electric conductivity of 0.07 µS/cm at 30°C. Then, a heat treatment was performed in a drying furnace at 80°C for 2 minutes under an atmospheric environment to obtain an aluminum foil.

### (Fourier transform infrared spectroscopy [FTIR] measurements)

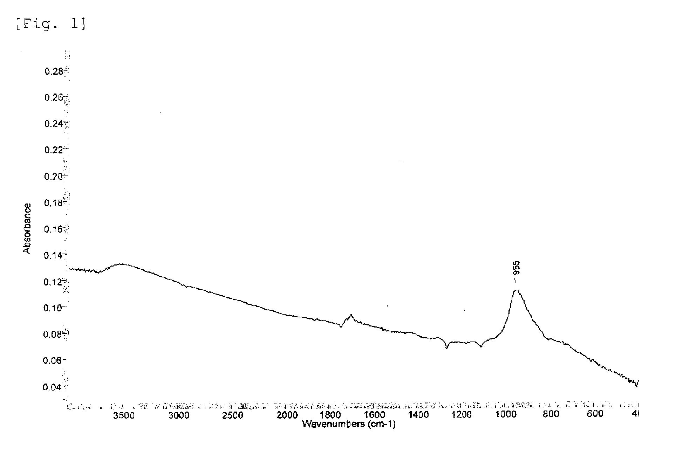

A surface of the aluminum foil obtained above was monitored for only parallel polarized light with a polarizer using a Fourier transform infrared spectroscopy system FTS-6000 from Varian Inc. set to an incident angle of 83°. A vapor deposited gold mirror was used as a background. The resolution was set to 4 cm⁻¹, and integration was performed 1000 times. For each peak showing an absorbance of 0.02 or more against the baseline, a wave number corresponding to the maximum absorbance was recorded as a peak position.
The peak positions for the aluminum foils obtained in Examples 1 to 3 are shown in Table 1. And the spectrum obtained from the Fourier transform infrared spectroscopy measurement of the surface of the aluminum foil obtained in Example 1 is shown in Fig. 1.

### (Formation of the coated layer containing an electrically conductive material)

Slurry was produced by combining 5 parts by mass of acetylene black (DENKI KAGAKU KOGYO K.K., Product name; Denka Black HS-100) as an electrically conductive material, 2.5 parts by mass of glyceryl chitosan as a binder manufactured by the method described in JP 3958536 B (corresponding to US 2004/092620 A1), 2.5 parts by mass of pyromellitic anhydride as an additive, and 90 parts by mass of N-methyl-2-pyrrolidone as a dispersion medium, and stirring them at a rotation speed of 300 rpm for 10 minutes using a dissolver type stirrer. This slurry was applied to one surface of the above aluminum foil with a bar coater, and dried at 180°C for 1 minute to manufacture a current collector comprising an aluminum foil and an undercoat layer. The thickness of the undercoat layer was 1 µm, and the layer weight per unit area was 0.5 g/m².

### (Example 4)

A current collector was manufactured by the same method as in Example 1 except that the chemical solution was changed to 1 % by mass of aqueous sodium hydroxide, and neutralization was performed with 1 mol/L of sulfuric acid before rinsing with pure water.

### (Comparative Example 1)

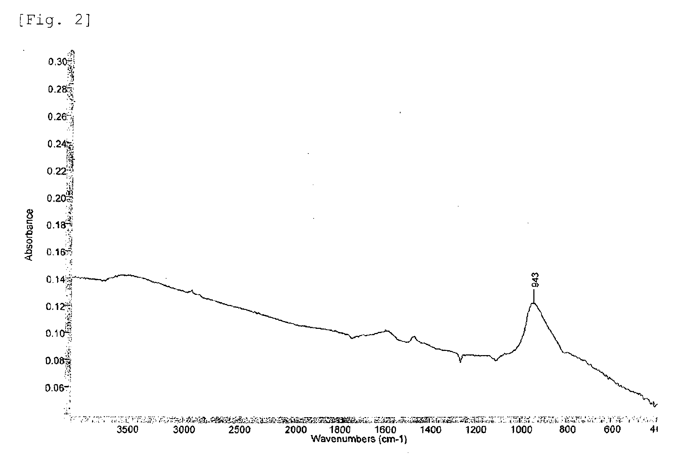

A current collector was manufactured by the same method as in Example 1 except that immersion washing with warm water for 1 minute was substituted for immersion washing with a chemical solution. Fig. 2 shows the spectrum obtained from the Fourier transform infrared spectroscopy measurement of a surface of the aluminum foil obtained by Comparative Example 1.

### (Initial penetration resistance)

The current collectors comprising the aluminum foils and an undercoat layer manufactured in Examples 1 to 4 and Comparative Example 1 were cut to prepare two sheets of current collector strips with 20 mm in width and 100 mm in length. The two current collector strips were stacked in a crossing fashion and placed on a vinyl chloride resin plate so that the surfaces on which the coated layers comprising an electrically conductive material were provided were faced each other, and the contact surface was 20 mm in length and 20 mm in width. A load of 1 kg/cm² was applied to the portion of the contact surface to secure the contact surface. Each of the ends where the current collector strips do not contact each other was connected to a milliohm meter to measure AC resistance of the current collector. The measured value was taken as penetration resistance. Low penetration resistance shows good suitability for an electrode of an electrochemical element. The evaluation results of the initial penetration resistance were shown with the following symbols according to the range of penetration resistance.
A : less than 100 mΩ
B : 100 mΩ to 150 mΩ
C : 150 mΩ or more

### (Time dependent change in penetration resistance)

The current collectors comprising the aluminum foils and an undercoat layer manufactured in Examples 1 to 4 and Comparative Example 1 were cut to prepare two sheets of current collector strips with 20 mm in width and 100 mm in length. The current collector strips were maintained at a temperature of 40°C under humidity of 80% for 24 hours. Then, penetration resistance was measured by the same method as described above, and a percentage of increase over the initial penetration resistance was computed. The evaluation results of the time dependent change in penetration resistance were shown with the following symbols according to the range of the percentage of increase.
○ : less than 200% of the percentage of increase
× : 200% or more of the percentage of increase

[Table 1]

**Table 1**

| | Example | | | | Comp. Ex. |
|---|---|---|---|---|---|
| | 1 | 2 | 3 | 4 | 1 |
| Chemical solution for washing | hydrochloric acid | hydrochloric acid | hydrochloric acid | Aqueous sodium hydroxide | Warm water |
| Thickness corresponding to a dissolved amount [nm] | 20 | 100 | 500 | 300 | 0 |
| FT-IR peak position [cm⁻¹] | 955 | 948 | 953 | 950 | 941 |
| Initial penetration resistance [mΩ] | 110 | 100 | 50 | 100 | 250 |
| Time dependent change in penetration resistance | ○ | ○ | ○ | ○ | × |

As shown in Table 1, the current collectors according to the present invention have low penetration resistance and small time dependent change in penetration resistance. This shows that an electrode in which the current collector according to the present invention is used can provide an electrochemical element having low internal resistance or impedance.

## Claims

1. A current collector for an electrochemical element comprising an aluminum foil showing a peak in the range between 945 cm⁻¹ and 962 cm⁻¹ in measurement of a surface layer of the aluminum foil by Fourier transform infrared spectroscopy.

2. The current collector for an electrochemical element according to claim 1, further comprising a coated layer comprising an electrically conductive material, on one or both surfaces of the aluminum foil.

3. The current collector for an electrochemical element according to claim 2, wherein the coated layer comprises a binder.

4. The current collector for an electrochemical element according to claim 3, wherein the binder comprises a polysaccharide.

5. The current collector for an electrochemical element according to claim 4, wherein the coated layer comprises carboxylic acid or a derivative thereof.

6. The current collector for an electrochemical element according to any one of claims 2 to 5, wherein the electrically conductive material is a carbonaceous material.

7. A method of manufacturing a current collector for an electrochemical element, the current collector comprising an aluminum foil showing a peak in the range between 945 cm⁻¹ and 962 cm⁻¹ in measurement of a surface layer of the aluminum foil by Fourier transform infrared spectroscopy, the method comprising the steps of; preparing an aluminum foil material; and washing a surface of the aluminum foil material with a chemical solution capable of dissolving aluminum.

8. The method of manufacturing a current collector for an electrochemical element according to claim 7, wherein the chemical solution is an acidic aqueous solution or an alkaline aqueous solution.

9. The method of manufacturing a current collector for an electrochemical element according to claim 7, wherein the chemical solution comprises one or more selected from the group consisting of hydrochloric acid, aqueous nitric acid and aqueous sulfuric acid.

10. The method of manufacturing a current collector for an electrochemical element according to claim 7, the chemical solution comprises one or more selected from the group consisting of aqueous solutions of alkali metal hydroxides and aqueous solutions of alkaline earth metal hydroxides.

11. The method of manufacturing a current collector for an electrochemical element according to any one of claims 7 to 10, further comprising a step of heat treating the aluminum foil at 70 to 200°C after the step of washing with the chemical solution.

12. The method of manufacturing a current collector for an electrochemical element according to any one of claims 7 to 11, further comprising a step of forming a coated layer comprising an electrically conductive material, on one or both surfaces of the aluminum foil.

13. The method of manufacturing a current collector for an electrochemical element according to claim 12, wherein the step of forming a coated layer comprises applying a coating fluid.

14. An electrode for an electrochemical element comprising the current collector for an electrochemical element according to any one of claims 1 to 6 and an active material layer provided on one or both surfaces of the current collector.

15. An electrochemical element comprising the electrode for an electrochemical element according to claim 14.

16. The electrochemical element according to claim 15, which is a lithium-ion secondary battery or an electric double layer capacitor.
